(19) Europäisches Patentamt

European Patent Office

Office européen des brevets

(11) **EP 0 736 976 A1**

## (12) EUROPEAN PATENT APPLICATION

(43) Date of publication:
09.10.1996 Bulletin 1996/41

(51) Int. Cl.6: **H03K 19/0948**, H03K 19/003

(21) Application number: 95105306.5

(22) Date of filing: 07.04.1995

(84) Designated Contracting States:
DE FR GB

(71) Applicants:
- YOZAN INC.
Tokyo 155 (JP)
- SHARP KABUSHIKı KAISHA
Osaka 545 (JP)

(72) Inventors:
- Shou, Guoliang
Tokyo 155 (JP)

- Takatori, Sunao
Tokyo 155 (JP)
- Yamamoto, Makoto
Tokyo 155 (JP)

(74) Representative: Grünecker, Kinkeldey,
Stockmair & Schwanhäusser
Anwaltssozietät
Maximilianstrasse 58
80538 München (DE)

(54) **Inverter circuit**

(57) This invention have an object to provide an inverter circuit to realize the stable efficient without the influence of the dispersion of characteristics value of each inverter, constructed by connecting a plural number of inverters INV1, INV2, ..., INVn in parallel between input terminal VIN and output terminal VOUT.

Figure 1

Figure 2

## Description

FIELD OF THE INVENTION

The present invention relates to an inverter circuit, especially to an inverter circuit using a plural number of C-MOS inverters.

BACKGROUND OF THE INVENTION

Conventionally, in an integrated circuit, a C-MOS inverter which is constructed by connecting pMOS type FET and nMOS type FET in parallel is used.

SUMMARY OF THE INVENTION

However, an inverter circuit constructed by conventional single inverter mentioned above has a problem that stable efficiency cannot be guaranteed because the settlement of threshold voltage and so on is changed due to the various type of efficiency of FET constructing the inverter.

The present invention is invented so as to solve the above conventional problem and have an object to provide an inverter circuit possible to realize the stable efficiency without the influence of inconstancy of the efficiency of the inverter.

The inverter circuit according to the present invention is characterized that a plural number of inverters between an input terminal and an output terminal in parallel in order to accomplish the above object.

BRIEF DESCRIPTION OF THE DRAWINGS

Figure 1 shows an circuit of an embodiment of an inverter circuit according to this invention.
Figure 2 shows a circuit with single inverter used in the circuit in Figure 1.
Figure 3 shows a graph of the characteristics of voltage of two single inverters, and that of the inverter circuit connected them in parallel.

PREFERRED EMBODIMENT OF THE PRESENT INVENTION

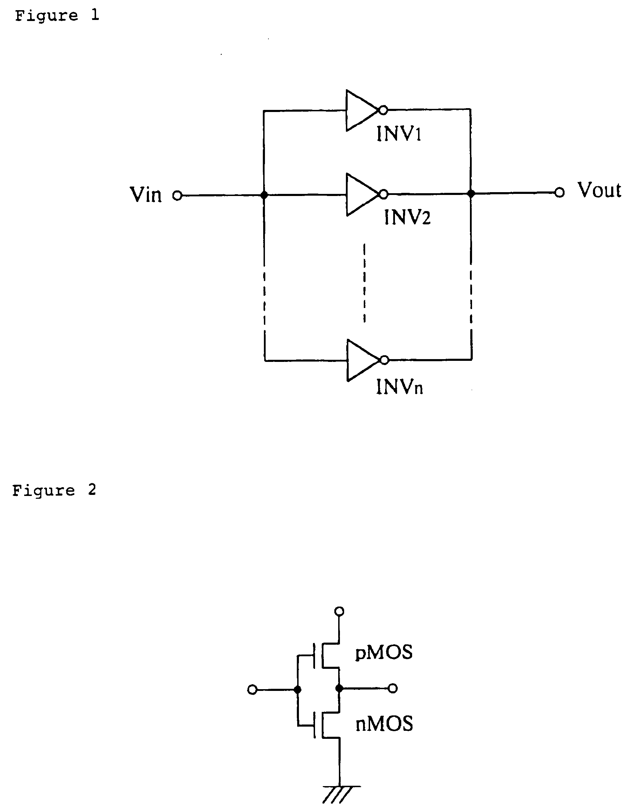

Hereinafter, the inverter circuit according to the present invention is described. The embodiment of the inverter circuit is, as shown in Figure 1, a plural number of inverters INV1, INV1, ..., INVn are connected in parallel between input terminal Vin and output terminal Vout.

Each inverter is a C-MOS inverter constructed by connecting pMOS type FET and nMOS type FET in parallel, as shown in Figure 2. The threshold voltage Vin of a single C-MOS inverter is shown in formula (1) below. In the formula, VDD is the source voltage to be impressed to pMOS type FET, Vtp is the threshold voltage of pMOS type FET and Vtn is the threshold voltage of nMOS type FET. When n number of inverters are connected in parallel, the threshold voltage Vin is expressed by formula (2).

$$Vin = (VDD + Vtp + Vtn \cdot \sqrt{(\beta n / \beta p)}) / (1 + \sqrt{(\beta n / \beta p)}) \qquad (1)$$

$$\Sigma \, \beta pi \cdot (Vin - VDD - Vtpi)^2 = \Sigma \, \beta ni \cdot (Vin - Vtni)^2 \qquad (2)$$

Here, $\beta p$ and $\beta n$ are coefficients expressed by the formulas (3) and (4). In the formulas, $\mu p$ and $\mu n$ are the mobility, $\varepsilon$ and tox are the dielectric constant of a gate oxide filter per a unit and the thickness of it, respectively, Lp and Ln are the width of a channel is Wp and Wn, and the length of a channel.

$$\beta p = (\mu p \varepsilon / tox) \cdot (Wp / Lp) \qquad (3)$$

$$\beta n = (\mu n \varepsilon / tox) \cdot (Wn / Ln) \qquad (4)$$

The dispersion of the threshold is appears by the value of $\beta$ by the regular distribution. However, in formula (2), it is not possible to solve the formula analytically because two terms of $\beta$ are included. Here, it is conventionally known that the efficiency become higher when bi-poler type transistor is connected in parallel. Generally, when elements are connected in parallel, each characteristics are averaged and statistically stable efficiency will be realized

This is confirmed by an experiment. According to a simulational experiment, the dispersion V1 (Vin) of the threshold voltage Vin in formula (1) is larger than the dispersion V2(Vin) of the threshold voltage Vin in formula (2).

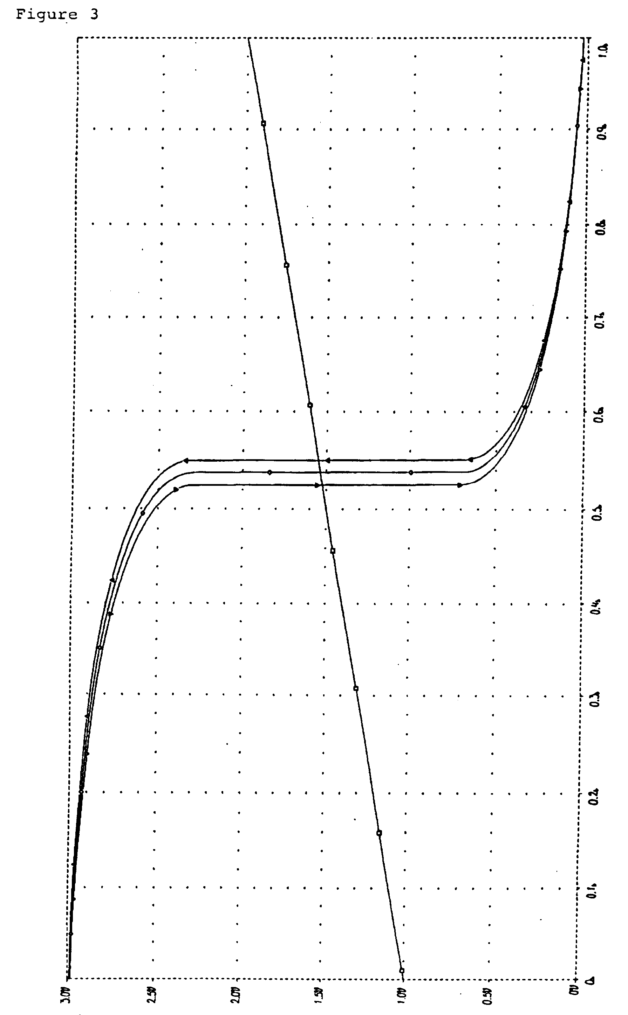

In Figure 3, it is shown a graph of the characteristics of the voltage when two inverters are connected in parallel. The line □ - □ in the graph is the voltage to be impressed in the input terminal Vin, the lines △ - △ and ▽ - ▽ are the characteristics of each inverter, and the line ◯ - ◯ is the characteristics of the inverter circuit connected two inverters in parallel.

As understood in Figure 3, connecting two inverters in parallel, the characteristics averaged the characteristics of each inverter can be obtained. The same effect can be obtained when the number of inverters is three or more. Therefore, connection of a plural number of inverters in parallel can inprove the accuracy of a threshold statistically than the case of single inverter.

As mentioned above, accoding to the present invention, the inverter circuit with statistically stable efficience can be realized by using a plural number of inverters in parallel and absorbing the dispersion of the characteristics of each inverter.

**Claims**

1. An inverter circuit characterized in that a plural number of inverters are settled in parallel between an input terminal and an output terminal.

2. An inverter circuit claimed in claim 1, characterized in that said inverter is constructed by pMOS type FET and nMOS type FET connected in parallel, and it is a C-MOS inverter.

Figure 1

Figure 2

Figure 3

**European Patent Office**

## EUROPEAN SEARCH REPORT

Application Number

EP 95 10 5306

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | US-A-4 716 312 (C.A. MEAD E.A.) * column 2, line 51 - column 3, line 3; figure 1 * | 1,2 | H03K19/0948 H03K19/003 |
| X | EP-A-0 550 216 (ADVANCED MICRO DEVICES INC.) * column 3, line 44 - column 6, line 32; figure 1 * | 1,2 | |
| A | PATENT ABSTRACTS OF JAPAN vol. 16 no. 486 (E-1276) ,8 October 1992 & JP-A-04 178018 (NEC CORP.) 25 June 1992, * abstract * | 1,2 | |
| X | PATENT ABSTRACTS OF JAPAN vol. 8 no. 95 (E-242) ,2 May 1984 & JP-A-59 012679 (DAINI SEIKOSHA KK) 23 January 1984, * abstract * | 1 | |
| | | | TECHNICAL FIELDS SEARCHED (Int.Cl.6) |
| | | | H03K |

The present search report has been drawn up for all claims

| Place of search | Date of completion of the search | Examiner |
|---|---|---|
| THE HAGUE | 19 May 1995 | Deconinck, E |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)